# EUROPEAN PATENT SPECIFICATION

(11) **EP 3 459 329 B1**
(45) Date of publication and mention of the grant of the patent: **25.10.2023**
(21) Application number: 16726072.8
(22) Date of filing: 27.05.2016
(51) Int. Cl.: H05K 7/20

(54) **COOLING UNIT WITH AIR AMPLIFICATION**
KÜHLEINHEIT MIT LUFTVERSTÄRKUNG
UNITÉ DE REFROIDISSEMENT AYANT UNE AMPLIFICATION D'AIR

(43) Date of publication of application: 27.03.2019
(73) Proprietor: Huawei Technologies Co., Ltd., Longgang District Shenzhen, Guangdong 518129 (CN)
(72) Inventor: TSOI, Vadim, 164 40 Kista (SE)
(74) Representative: Körber, Martin Hans
(86) International application number: PCT/EP2016/061970
(87) International publication number: WO 2017/202471

(56) References cited:
- EP-A1- 2 955 985
- DE-A1- 1 908 825
- DE-A1- 3 509 908
- US-A1- 2010 008 025

## Description

### TECHNICAL FIELD

The invention relates to a cooling unit for a remote radio unit. The invention also relates to a remote radio unit and the use of a cooling unit for cooling an electronics device.

### BACKGROUND

Radio remote units that are in use in modem radio base station system can have a high heat load and thus significant cooling demand. However, natural convection cooling has limited capacity. Thus, there is an interest in providing improved fan cooling for radio remote units and other electronic devices.

US 2010/008025 A1 discloses a rack, which houses rackable electronic gear modules and is cooled by natural air convection thanks to ventilation orifices provided in its bottom and top walls and by forced air convection thanks to internal air distribution ramps fed with air under pressure through the intermediary of a distribution box connected to a forced air circulation duct.

EP 2 955 985 A1 provides a radio remote unit, including a unit body, and multiple heat dissipation fins that are disposed on a surface of the body, where an opening groove is disposed on the heat dissipation fin, and opening grooves on the multiple heat dissipation fins form a fan ventilation groove, where the fan ventilation groove is connected to ventilation channels between the heat dissipation fins; and a fan is disposed in a built-in manner in the fan ventilation groove. The fan ventilation groove formed by the opening grooves on the multiple heat dissipation fins is connected to the ventilation channels between the heat dissipation fins in order to improve heat dissipation.

DE 35 09 908 A1 relates to a cooling device for forced cooling of arranged plug-in assemblies. According to the invention, a cooling tube which is arranged in the mounting rack is provided with a cooling nozzle which is aligned to a local hot spot of the plug-in assembly, and a gaseous cooling medium can be supplied to the cooling tube. A cooling device for forced cooling of local hot spots on plug-in assemblies is thus obtained, said hot spots being cooled in an objective manner.

DE 19 08 825 A1 discloses a gas cooling system for heavily loaded electrical components, which has the cooling gas passed under pressure through cooling lines laid adjacent to the components requiring cooling. The lines have outlets directed at each component to allow the gas to flow over the component. The outlet openings are smaller than the lines' cross-section and are perpendicular to the support holding the components. The openings may be on one or both sides of the line and arranged so that the gas flows over the component parallel to or at an angle to the plane of the support. Several openings may be situated around each component.

### SUMMARY OF THE INVENTION

The objective of the invention is to provide a cooling unit and a radio remote unit, wherein the cooling unit and the radio remote unit overcome one or more of the above-mentioned problems of the prior art.

A first aspect of the invention provides a cooling unit for an electronics device, the cooling unit comprising a channel with an inlet for intake of pressurized airflow and one or more outlet nozzles arranged along the channel, wherein each of the outlet nozzles is configured to, driven by the pressurized airflow, suck in surrounding air from one or more additional openings formed between the outlet nozzle and a diffuser, wherein the diffuser surrounds the outlet nozzle and the one or more openings comprise a first opening defined by the area between the diffuser and a first side of the outlet nozzle and a second opening defined by the area between the diffuser and a second side of the outlet nozzle.

The cooling unit of the first aspect provides an improved cooling of the electronics device because it is not only the pressurized airflow that can cool the electronics device, but there is also surrounding air sucked by the outlet nozzles, thus creating an additional airflow for cooling the electronics device. This combination of original airflow (created by the pressurized airflow provided to the inlet of the channel) plus the surrounding air that is sucked by the outlet nozzles is in the following also referred to as air amplification.

The electronics device can be in particular a remote radio unit (RRU), in particular a RRU of a base station of a communication network.

The pressurized air can be provided e.g. by one or more fans that are arranged near the inlet of the channel. The channel can have a T-shape.

Embodiments of the cooling unit of the first aspect can achieve a higher air flow, a better directionality of the air flow and/or a higher air velocity. This results in better cooling or can result in lower energy requirements for fans driving the cooling unit.

In a preferred embodiment, jet airflow created by the outlet nozzles creates zones with lower pressure around (e.g. below and above) the jet air flow. As a result of the pressure drop (e.g. the pressure drop between normal atmospherically pressure and lower pressure along the Jet flow) an additional suction of surrounding air to the main air stream is achieved, i.e., an air amplification is achieved.

In a first implementation of the cooling unit according to the first aspect, at least one of the outlet nozzles further comprises an insert element arranged in an opening of the nozzle, such that a second opening is formed between the outlet nozzles and the insert element.

The insert element has the advantage that a further additional airflow can be created, thus providing an even stronger cooling effect for the electronics device. Also, the insert element can act as guidance for the airflow from the outlet nozzle. This has the advantage that airflow, local speed of airflow and blow direction can be controlled. This can improve the cooling capacity.

In a second implementation of the cooling unit according to the first aspect as such or according to the first implementation, the insert element has a drop-like shape.

Preferably, the insert element has a drop-like shape at least in one cross section of the insert element.

Experiments have shown that a drop-like shape of the insert element is particularly advantageous for achieving an optimum airflow and air amplification effect.

In a third implementation of the cooling unit according to the first aspect as such or according to the first or second implementation, at least one of the outlet nozzles has a shape of a tapered cylinder.

Experiments have shown that the tapered cylinder shape can lead to an additional compression of the air as it leaves the outlet nozzles. Thus, an increased exit velocity and an increased air amplification can be achieved.

In a fourth implementation of the cooling unit according to the first aspect as such or according to one of the previous implementations, the cooling unit further comprises a heat sink with a first and a second plurality of fins, wherein the outlet nozzles are configured to suck in air from areas between the first plurality of fins and/or to blow air towards the second plurality of fins, wherein the first and the second plurality of fins are arranged on opposite sides of the channel.

As the channel of the cooling unit of the fourth implementation is both sucking in air on one side and blowing out air on another side of the channel, air cooling can be achieved both on the first plurality of fins and on the second plurality of fins. Thus, a superior cooling of a radio remote unit can be achieved.

In a fifth implementation of the cooling unit according to the fourth implementation of the first aspect, the first and the second plurality of fins are located on a common heat sink plate.

The common heat sink plate can be part of the cooling unit or can be provided as a separate component. Having a common heat sink plate has the advantage that an increased stability of the cooling unit is achieved. Also, a heat exchange between the first and the second plurality of fins can be achieved through the common heat sink plate. The common heat sink plate and/or the first and second plurality of fins can e.g. be made of metal.

In a sixth implementation of the cooling unit according to the fourth or fifth implementation of the first aspect, the outlet nozzles are arranged to correspond to openings between the plurality of fins.

In other words a distance between the outlet nozzles can be the same as a distance between fins of the first plurality of fins and/or the distance between the outlet nozzles can be the same as a distance between fins of the second plurality of fins. This has the advantage that the air streams generated by the outlet nozzles are aligned with the areas between the fins.

In a seventh implementation of the cooling unit according to the first aspect as such or according to one of the previous implementations, the outlet nozzles are oriented in a direction that is orthogonal to a direction of the channel.

This has the advantage that the cooling unit can be assembled efficiently and also provides a good cooling. In particular, the cooling unit can be used with standard fins.

In an eighth implementation of the cooling unit according to the first aspect as such or according to one of the previous implementations, the inlet opening is located at one end of the channel and the channel is tapered towards an opposite end of the channel.

This has the advantage that an equal pressure drop can be achieved. This can lead to an equal or similar airflow from all outlet nozzles, which is advantageous for optimum cooling. In a preferred embodiment, the channel can have a pyramid shape.

In a ninth implementation of the cooling unit according to the first aspect as such or according to one of the previous implementations, an outlet area of one or more of the outlet nozzles is rectangular. A rectangular outlet area can be manufactured with particularly low manufacturing cost.

In a tenth implementation of the cooling unit according to the first aspect as such or according to one of the previous implementations, the one or more fans comprise a first and a second fan, wherein the first fan and the second fan are arranged one behind the other. This has the advantage that a higher pressure drop can be applied and an improved fan failure behavior is achieved.

In an eleventh implementation of the cooling unit according to the first aspect as such or according to one of the previous implementations of the first aspect, the cooling unit further comprises one or more further openings that are directed towards a common heat sink plate that is arranged in parallel to the channel. This has the advantage that cooling of additional hot spots can be provided on the common heat sink plate.

A second aspect of the invention refers to a remote radio unit which comprises a cooling unit according to the first aspect as such or one of the implementations of the first aspect. A third aspect of the invention refers to the use of a cooling unit of the first aspect as such or one of the implementations of the first aspect, for cooling a remote radio unit.

Experiments have shown that the cooling unit of the first aspect is of particular usefulness when cooling radio remote units.

The methods according to the second aspect of the invention can be performed by the cooling unit according to the first aspect of the invention. Further features or implementations of the method according to the second aspect of the invention can perform the functionality of the cooling unit according to the first aspect of the invention and its different implementation forms.

### BRIEF DESCRIPTION OF THE DRAWINGS

To illustrate the technical features of embodiments of the invention more clearly, the accompanying drawings provided for describing the embodiments are introduced briefly in the following. The accompanying drawings in the following description are merely some embodiments of the invention, but modifications on these embodiments are possible without departing from the scope of the invention as defined in the claims.
- FIG. 1A: is a schematic illustration of a cooling unit in accordance with an embodiment of the invention,
- FIG. 1B: is a schematic illustration of one of the outlet nozzles from the cooling unit of FIG. 1A with a diffuser arranged around the outlet nozzle, in accordance with a further embodiment of the invention,
- FIG. 2: is a schematic illustration of a cross-section of a cooling unit in accordance with a further embodiment of the invention,
- FIG. 3: is a schematic illustration of a cross-section of a cooling unit in accordance with a further embodiment of the invention, wherein an insert element is arranged within an outlet nozzle,
- FIG. 4: is a schematic illustration of a cross-section of a cooling unit in accordance with a further embodiment of the invention, wherein an outlet nozzle has a shape of a tapered cylinder,
- FIG. 5: is a schematic illustration of a cross-section of a cooling unit in accordance with a further embodiment of the invention, wherein the channel further comprises a further opening that is directed at a common heat sink plate,
- FIG. 6: is a schematic illustration of a cooling unit in accordance with a further embodiment of the invention,
- FIGs. 7 and 8: are schematic illustrations of cross sections of further cooling units in accordance with further embodiments of the invention,
- FIG. 9A: illustrates an arrangement of two fans in accordance with a further embodiment of the invention, and
- FIG. 9B: is a schematic illustration of a cooling unit comprising two fans in accordance with a further embodiment of the invention.

### Detailed Description of the Embodiments

In the following Figures, same or similar elements can be indicated with same reference numbers.

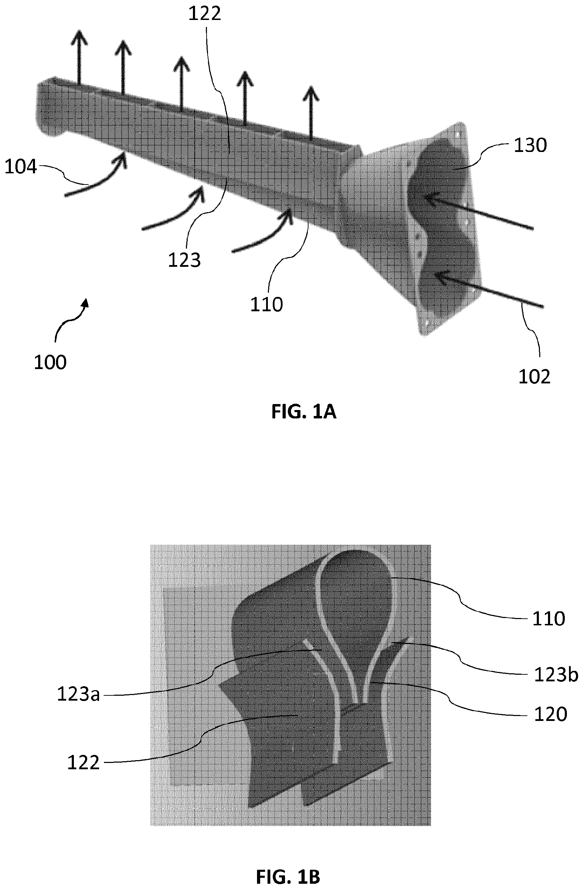

FIG. 1A shows a schematic illustration of a cooling unit 100. The cooling unit 100 comprises a channel 110 with an inlet 130 for intake of pressurized airflow 102 and one or more outlet nozzles that are arranged along the channel 110. The outlet nozzles are not visible in FIG. 1A because they are surrounded by diffusers 122. The channel 110 of FIG. 1A comprises five outlet nozzles and five diffusers 122 that are arranged around the corresponding outlet nozzles. The diffuser 122 is arranged such that an opening 123 for intake of surrounding air 104 is formed.

FIG. 1B is an schematic illustration of an outlet nozzle 120 from the cooling unit of FIG. 1A. the outlet nozzle 120 is surrounded by a diffuser 122. The area between the outlet nozzle 120 and the diffuser 122 defines a first opening 123a on a first side of the outlet nozzle 120 and a second opening 123b on a second side of the outlet nozzle 120. The outlet nozzle 120 is configured as one piece with the channel 110.

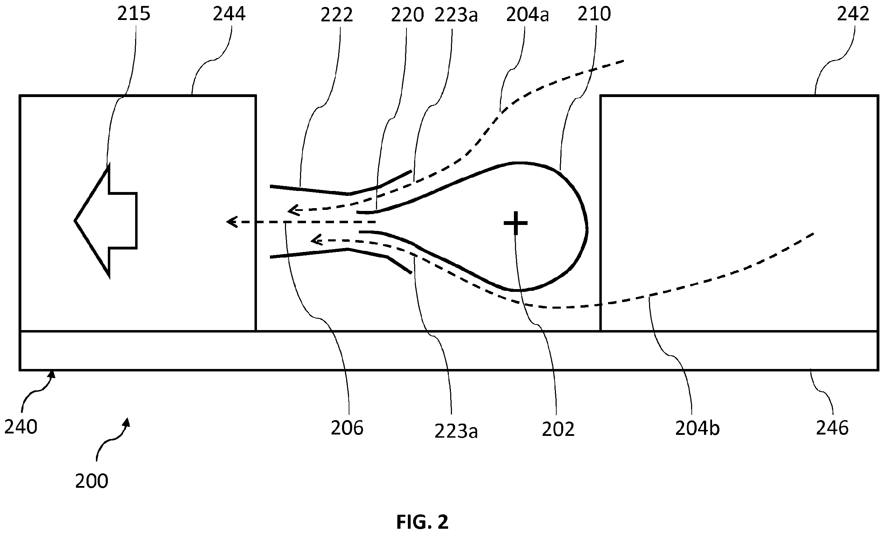

FIG. 2 is a schematic illustration of a cross-section of a cooling unit 200. The cross section shows a first fin from a first plurality of fins 242 and a second fin from a second plurality of fins 244. A channel 210 is arranged between the fins 242, 244 and above a common heat sink plate 246. The first and second plurality of fins and the common heat sink plate 246 are part of a heat sink 240.

The channel 210 carries pressurized airflow 202 through the channel. The pressurized airflow 202 exits the channel 210 through an outlet nozzle 220 as pressurized air stream 206. The pressurized air stream 206 causes a sucking of surrounding air 204a, 204b from both above and below the channel. In particular, the surrounding air 204a, 204b is sucked from an area next to the first fin 242 into openings 223a, 223b that are defined by the nozzle 220 and the surrounding diffuser 222.

The large arrow with reference number 215 indicates a total airflow that is the sum of the individual airflows 204a, 204b and 206.

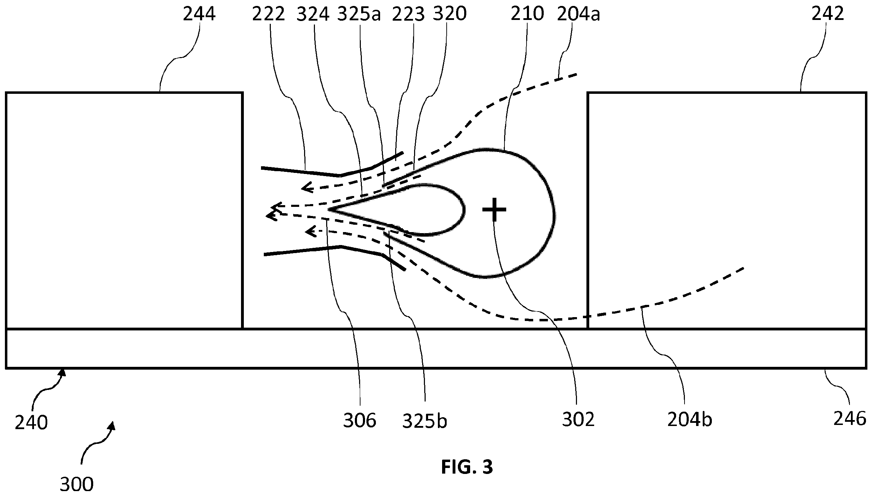

FIG. 3 is a schematic illustration of a cross-section of a cooling unit 300. The cooling unit 300 has similarities with the cooling unit 200 of FIG. 2, however, it comprises an outlet nozzle 320 comprises an insert element 324 arranged within the outlet nozzle 320. This has the effect that the pressurized air 302 is pushed out through two openings 325a, 325b above and below the insert element 324, thus creating two pressurized air streams 306.

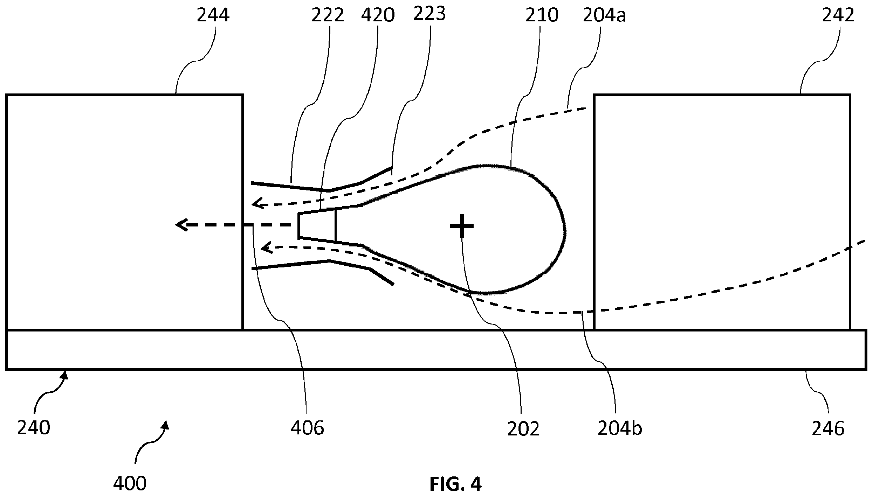

FIG. 4 is a schematic illustration of a cross-section of a cooling unit, wherein an outlet nozzle 420 has a shape of a tapered cylinder. The tapered cylinder shape causes an increase of the pressure as the pressurized air passes through the nozzle 420. Thus, the pressurized air stream 406 that is pushed out of the nozzle 420 has a higher pressure and can have a bigger air amplification effect.

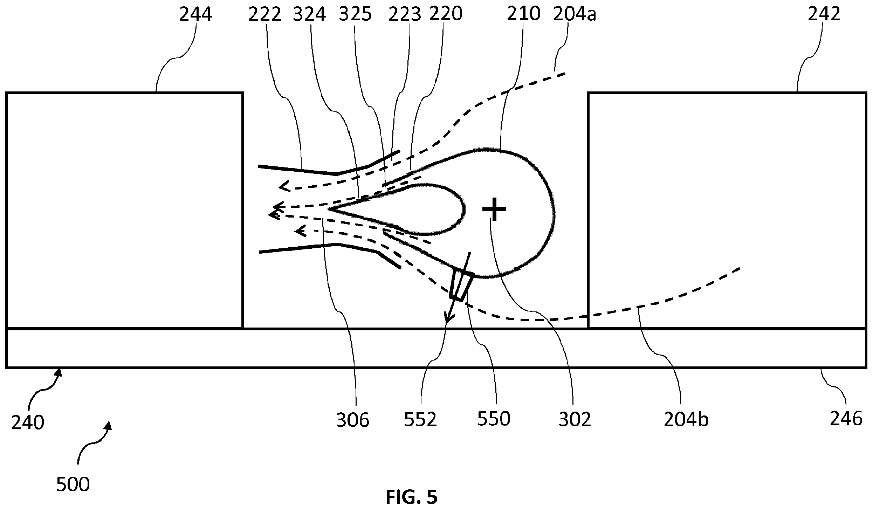

FIG. 5 is a schematic illustration of a cross-section of a cooling unit 500 that is similar to the cooling unit 300 of FIG. 3. It further comprises a further opening 550 that is directed towards the common heat sink plate 246. Thus, a further air stream 552 is created that provides cooling to the common heat sink plate and/or a further device that is located under the channel 310.

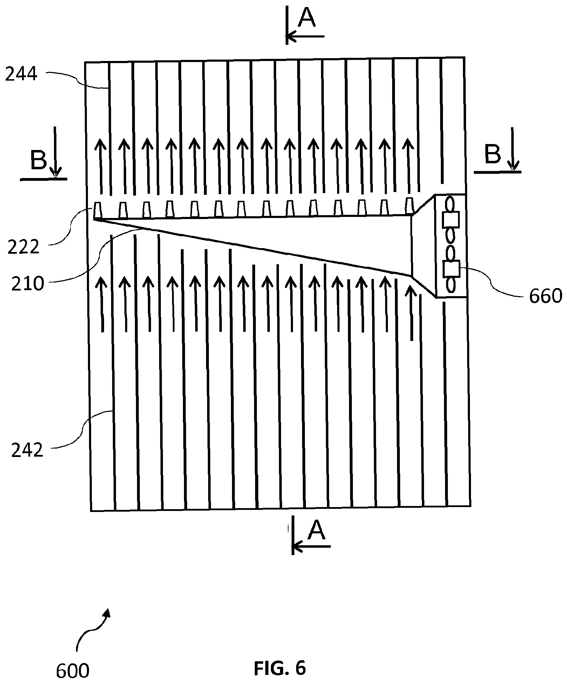

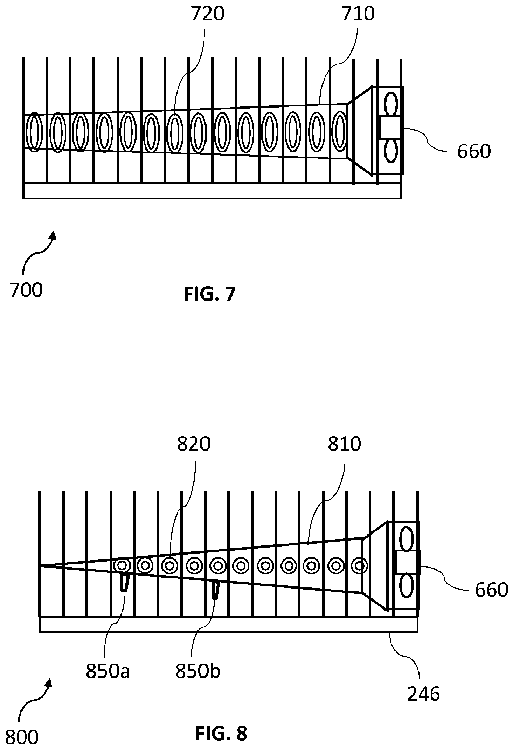

FIG. 6 is a schematic illustration of a cooling unit 600. The cross-sections shown in FIGs. 2 to 5 correspond to the plane indicated with "A" in FIG. 6 and the cross-sections shown in FIG. 6 and FIG. 7 correspond to the plane indicated with "B" in FIG. 7. The cooling unit 600 comprises two fans 660 that are arranged next to each other. The diffusers 222 cover outlet nozzles that are arranged along the channel 210. In detail, the setup can be as shown e.g. in FIG. 4.

FIG. 7 is a schematic illustration of a cross section of a cooling unit 700. The cooling unit comprises a channel 710 which has a plurality of outlet nozzles 720 arranged along its length. The outlet nozzles 720 have an oval shape and have diffusers arranged around them (not shown in FIG. 7). Pressurized airflow is pushed into the channel 710 by the fans 660.

FIG. 8 is a schematic illustration of a cross section of a further cooling unit 800. The cooling unit comprises a channel 810 which has a shape of a pyramid. A plurality of outlet nozzles 820 with circle-shaped openings are arranged along the length of the channel 810. The outlet nozzles 820 have diffusers arranged around them (not shown in FIG. 8). The cooling unit 800 comprises further openings 850a, 850b that are directed towards the common heat sink plate 246. In detail, the setup can be as shown in FIG. 4.

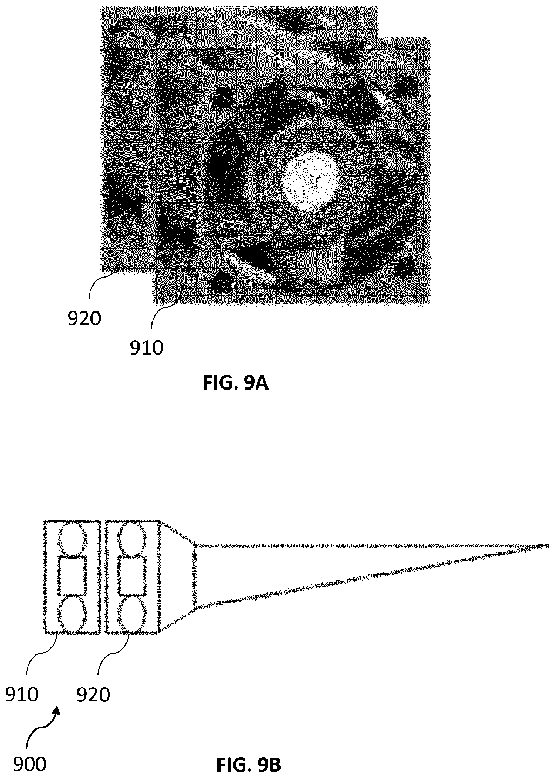

FIG. 9A shows an arrangement of two fans 910, 920. The fans are arranged one behind the other and can be used to drive pressurized airflow into a channel of a cooling unit.

FIG. 9B is a schematic illustration of a cooling unit 900 that comprises the two fans 910, 920 arranged to drive the pressurized airflow into a channel with a pyramid shape (outlet nozzles not shown in FIG. 9B).

## Claims

1. A cooling unit (100; 200; 300; 400; 500; 600; 700; 900) for an electronics device, the cooling unit comprising a channel (110; 210; 710; 810) with an inlet (130) for intake of pressurized airflow and one or more outlet nozzles (120; 220; 320; 420; 720; 820) arranged along the channel, wherein each of the outlet nozzles is configured to, driven by the pressurized airflow (102; 202), suck surrounding air (104; 204a, 204b) from one or more additional openings (223) formed between the outlet nozzle and a diffuser (122; 222), wherein the diffuser surrounds the outlet nozzle and the one or more openings comprise a first opening (123a) defined by the area between the diffuser and a first side of the outlet nozzle (120) and a second opening (123b) defined by the area between the diffuser and a second side of the outlet nozzle (120).

2. The cooling unit of claim 1, wherein at least one of the outlet nozzles (320) further comprises an insert element (324) arranged in an opening (325) of the outlet nozzle, such that a further opening is formed between the at least one of the outlet nozzles and the insert element.

3. The cooling unit of claim 2, wherein the insert element (324) has a drop-like shape.

4. The cooling unit of one of the previous claims, wherein at least one of the outlet nozzles (420) has a shape of a tapered cylinder.

5. The cooling unit of one of the previous claims, further comprising a heat sink (240) with a first and a second plurality of fins (242, 244), wherein the outlet nozzles (120; 220; 320; 420) are configured to suck in air from areas between the first plurality of fins and/or to blow air towards the second plurality of fins, wherein the first and the second plurality of fins are arranged on opposite sides of the channel (110; 210; 710; 810).

6. The cooling unit of claim 5, wherein the first and the second plurality of fins (242, 244) are located on a common heat sink plate (246).

7. The cooling unit of one of claims 5 and 6, wherein the outlet nozzles (420) are arranged to correspond to openings between the plurality of fins (242, 244).

8. The cooling unit of one of the previous claims, wherein the outlet nozzles (420) are oriented in a direction that is orthogonal to a direction of the channel (110; 210; 710; 810).

9. The cooling unit of one of the previous claims, wherein the inlet opening (130) is located at one end of the channel (110) and the channel is tapered towards an opposite end of the channel (110; 210; 710; 810).

10. The cooling unit of one of the previous claims, wherein an outlet area of one or more of the outlet nozzles is rectangular.

11. The cooling unit of one of the previous claims, further comprising a first and a second fan (660; 910, 920) for creation of the pressurized airflow, wherein the first fan (910) and the second fan (920) are arranged one behind the other.

12. The cooling unit of one of the previous claims, further comprising one or more further openings (550; 850a, 850b) that are directed towards a common heat sink plate (246) that is arranged in parallel to the channel (110; 210; 710; 810).

13. A remote radio unit comprising a cooling unit according to one of the previous claims.

14. Use of a cooling unit of one of claims 1 to 12 for cooling a remote radio unit.

## Patentansprüche

1. Kühleinheit (100; 200; 300; 400; 500; 600; 700; 900) für eine elektronische Vorrichtung, wobei die Kühleinheit einen Kanal (110; 210; 710; 810) mit einem Einlass (130) zum Ansaugen eines unter Druck stehenden Luftstroms und eine oder mehrere Auslassdüsen (120; 220; 320; 420; 720; 820), die entlang des Kanals angeordnet sind, umfasst, wobei jede der Auslassdüsen dazu konfiguriert ist, angetrieben durch den unter Druck stehenden Luftstrom (102; 202), Umgebungsluft (104; 204a, 204b) aus einer oder mehreren zusätzlichen Öffnungen (223) zu saugen, die zwischen der Auslassdüse und einem Diffusor (122; 222) gebildet sind, wobei der Diffusor die Auslassdüse umgibt und die eine oder die mehreren Öffnungen eine erste Öffnung (123a), die durch den Bereich zwischen dem Diffusor und einer ersten Seite der Auslassdüse (120) definiert ist, und eine zweite Öffnung (123b), die durch den Bereich zwischen dem Diffusor und einer zweiten Seite der Auslassdüse (120) definiert ist, umfassen.

2. Kühleinheit nach Anspruch 1, wobei mindestens eine der Auslassdüsen (320) ferner ein Einsatzelement (324) umfasst, das in einer Öffnung (325) der Auslassdüse angeordnet ist, derart, dass eine weitere Öffnung zwischen der mindestens einen der Auslassdüsen und dem Einsatzelement gebildet ist.

3. Kühleinheit nach Anspruch 2, wobei das Einsatzelement (324) eine tropfenartige Form aufweist.

4. Kühleinheit nach einem der vorhergehenden Ansprüche, wobei mindestens eine der Auslassdüsen (420) die Form eines konischen Zylinders aufweist.

5. Kühleinheit nach einem der vorhergehenden Ansprüche, die ferner einen Kühlkörper (240) mit einer ersten und einer zweiten Vielzahl von Lamellen (242, 244) umfasst, wobei die Auslassdüsen (120; 220; 320; 420) dazu konfiguriert sind, Luft aus Bereichen zwischen der ersten Vielzahl von Lamellen anzusaugen und/oder Luft in Richtung der zweiten Vielzahl von Lamellen zu blasen, wobei die erste und die zweite Vielzahl von Lamellen auf gegenüberliegenden Seiten des Kanals (110; 210; 710; 810) angeordnet sind.

6. Kühleinheit nach Anspruch 5, wobei sich die erste und die zweite Vielzahl von Lamellen (242, 244) auf einer gemeinsamen Kühlkörperplatte (246) befinden.

7. Kühleinheit nach einem der Ansprüche 5 und 6, wobei die Auslassdüsen (420) so angeordnet sind, dass sie Öffnungen zwischen der Vielzahl von Lamellen (242, 244) entsprechen.

8. Kühleinheit nach einem der vorhergehenden Ansprüche, wobei die Auslassdüsen (420) in einer Richtung ausgerichtet sind, die orthogonal zu einer Richtung des Kanals (110; 210; 710; 810) ist.

9. Kühleinheit nach einem der vorhergehenden Ansprüche, wobei sich die Einlassöffnung (130) an einem Ende des Kanals (110) befindet und der Kanal in Richtung eines gegenüberliegenden Endes des Kanals (110; 210; 710; 810) konisch zuläuft.

10. Kühleinheit nach einem der vorhergehenden Ansprüche, wobei ein Auslassbereich einer oder mehrerer der Auslassdüsen rechteckig ist.

11. Kühleinheit nach einem der vorhergehenden Ansprüche, die ferner einen ersten und einen zweiten Lüfter (660; 910, 920) zum Erzeugen des unter Druck stehenden Luftstroms umfasst, wobei der erste Lüfter (910) und der zweite Lüfter (920) hintereinander angeordnet sind.

12. Kühleinheit nach einem der vorhergehenden Ansprüche, die ferner eine oder mehrere weitere Öffnungen (550; 850a, 850b) umfasst, die auf eine gemeinsame Kühlkörperplatte (246) gerichtet sind, die parallel zu dem Kanal (110; 210; 710; 810) angeordnet ist.

13. Fernfunkeinheit, die eine Kühleinheit nach einem der vorhergehenden Ansprüche umfasst.

14. Verwendung einer Kühleinheit nach einem der Ansprüche 1 bis 12 zum Kühlen einer Fernkfunkeinheit.

## Revendications

1. Unité de refroidissement (100 ; 200 ; 300 ; 400 ; 500 ; 600 ; 700 ; 900) pour un dispositif électronique, l'unité de refroidissement comprenant un canal (110 ; 210 ; 710 ; 810) avec une entrée (130) pour l'admission de flux d'air sous pression et une ou plusieurs buses de sortie (120 ; 220 ; 320 ; 420 ; 720 ; 820) agencées le long du canal, dans laquelle chacune des buses de sortie est configurée pour, entraînée par le flux d'air sous pression (102 ; 202), aspirer l'air environnant (104 ; 204a, 204b) d'une ou plusieurs ouvertures supplémentaires (223) formées entre la buse de sortie et un diffuseur (122 ; 222), dans laquelle le diffuseur entoure la buse de sortie et les une ou plusieurs ouvertures comprennent une première ouverture (123a) définie par la zone entre le diffuseur et un premier côté de la buse de sortie (120) et une seconde ouverture (123b) définie par la zone entre le diffuseur et un second côté de la buse de sortie (120).

2. Unité de refroidissement selon la revendication 1, dans laquelle au moins l'une des buses de sortie (320) comprend en outre un élément d'insertion (324) agencé dans une ouverture (325) de la buse de sortie, de sorte qu'une autre ouverture est formée entre l'au moins une des buses de sortie et l'élément d'insertion.

3. Unité de refroidissement selon la revendication 2, dans laquelle l'élément d'insertion (324) a une forme en forme de goutte.

4. Unité de refroidissement selon l'une des revendications précédentes, dans laquelle au moins l'une des buses de sortie (420) a une forme de cylindre tronconique.

5. Unité de refroidissement selon l'une des revendications précédentes, comprenant en outre un dissipateur thermique (240) avec une première et une seconde pluralité d'ailettes (242, 244), dans laquelle les buses de sortie (120 ; 220 ; 320 ; 420) sont configurées pour aspirer de l'air depuis des zones entre la première pluralité d'ailettes et/ou pour souffler de l'air vers la seconde pluralité d'ailettes, dans laquelle la première et la seconde pluralité d'ailettes sont agencées sur des côtés opposés du canal (110 ; 210 ; 710 ; 810).

6. Unité de refroidissement selon la revendication 5, dans laquelle la première et la seconde pluralité d'ailettes (242, 244) sont situées sur une plaque de dissipateur thermique commune (246).

7. Unité de refroidissement selon l'une des revendications 5 et 6, dans laquelle les buses de sortie (420) sont agencées pour correspondre à des ouvertures entre la pluralité d'ailettes (242, 244).

8. Unité de refroidissement selon l'une des revendications précédentes, dans laquelle les buses de sortie (420) sont orientées selon une direction orthogonale à une direction du canal (110 ; 210 ; 710 ; 810).

9. Unité de refroidissement selon l'une des revendications précédentes, dans laquelle l'ouverture d'entrée (130) est située à une extrémité du canal (110) et le canal est effilé vers une extrémité opposée du canal (110 ; 210 ; 710 ; 810).

10. Unité de refroidissement selon l'une des revendications précédentes, dans laquelle une zone de sortie d'une ou plusieurs des buses de sortie est rectangulaire.

11. Unité de refroidissement selon l'une des revendications précédentes, comprenant en outre un premier et un second ventilateur (660 ; 910, 920) pour la création du flux d'air sous pression, dans laquelle le premier ventilateur (910) et le second ventilateur (920) sont agencés l'un derrière l'autre.

12. Unité de refroidissement selon l'une des revendications précédentes, comprenant en outre une ou plusieurs ouvertures supplémentaires (550 ; 850a, 850b) qui sont dirigées vers une plaque de dissipation thermique commune (246) qui est agencée parallèlement au canal (110 ; 210 ; 710 ; 810).

13. Unité radio distante comprenant une unité de refroidissement selon l'une des revendications précédentes.

14. Utilisation d'une unité de refroidissement selon l'une des revendications 1 à 12 pour refroidir une unité radio distante.
